# EUROPEAN PATENT SPECIFICATION

(11) **EP 1 942 710 B1**
(45) Date of publication and mention of the grant of the patent: **11.05.2011**
(21) Application number: 07100104.4
(22) Date of filing: 04.01.2007
(51) Int. Cl.: H05K 3/12, H05K 1/16

(54) **Method of generating an electrical component of an electrical circuitry on a substrate**
Verfahren zur Herstellung einer elektrischen Komponente eines elektrischen Schaltkreises auf einem Substrat
Procédé de génération d'un composant électrique d'un circuit électrique sur un substrat

(43) Date of publication of application: 09.07.2008
(73) Proprietor: Oticon A/S, 2765 Smørum (DK)
(72) Inventor: Bill, Thomas, DK-2765, Smørum (DK)

(56) References cited:
- US-A- 5 741 557
- US-A1- 2003 072 140
- US-A1- 2004 209 004

## Description

The present invention refers to a method of generating an electrical component, particularly for a hearing aid electrical circuitry, on a substrate.

### BACKGROUND OF THE INVENTION

It is well known that passive and active components in hearing aids, but also in other technical fields need highly precise characteristics in order to perform correctly. The characteristic parameters could be e.g. the conductivity, the resistance, the capacity, the inductivity, the Q-value, the frequency etc.

When passive and active components of hearing aid electrical circuitry are manufactured by material deposition on a substrate, they normally show a deviation of their characteristic value from a precise desired value after the material deposition step. Since this deviation of the characteristic parameter of the deposited electrical component may cause a corresponding deviation of the performance of the electrical component or of the electrical circuitry including such electrical component from the required performance of the system, it is either necessary to include a trimming or tuning or adjusting element in the respective electrical circuitry of the hearing aid to counteract the undesired performance deviation or it is necessary to provide, after the material deposition step, a trimming step correcting the shape and/or other properties of the deposited electrical component so that, finally, it reaches the desired value of its characteristic parameters.

Both approaches have inherent disadvantages in that providing a trimming or tuning or adjusting element added to the electrical circuitry in the hearing aid requires additional space or area on the substrate which may be unacceptable in the extremely limited space environment of hearing aids. The second approach complicates the manufacturing method and adds to the production costs.

US 005683928 A discloses a method for fabricating thin film resistors by depositing the thin film electronic components on a substrate surface without having precise depositions of all of the pre-patterned materials. The parameter values of the components are thereafter measured or estimated and a correction offset file is generated and the components are trimmed e.g. by changing the physical length of an inductor coil or resistor lead of by changing a capacitor lead area in order to achieve the size parameter values after the material depositions has been carried out.

A similar technique is disclosed in US 20040099647 A1 wherein resistors are produced and trimmed to a desired resistor value by laser trimming after production of the respective resistor in accordance with measurement results collected after production of the resistors.

US 6,256,866 B1 describes a method of manufacturing a printed circuit board with a polymer thick-film resistor whose dimensions can be defined with improved precision. This is achieved by precisely dimensioning the distance of copper terminations determining the effective length of the resistor material deposited by printing, whereas the cross-section dimension of the resistor is determined by the deposition process. Any deviation of this cross-section, of course, causes corresponding deviation of the resistor value from a desired value.

US 2003/0072140 A1 discloses a method for manufacturing a resistive element on a printed circuit board. The resistive element is formed on the printed circuit board by dispensing resistive material onto the board between two predefined contact points. The document mentions that the resistance between the contact points may be measured during dispensing in order to achieve a precise amount of resistance between the contact points.

US 5,741,557 discloses a method for depositing fine lines of a material on a substrate. The lines are formed by tracing along the substrate a heated tip wetted with the material in the molten state. The document mentions that in the case that the material is a metal, continuity of the deposited line may be tested during depositing by means of two test probes usable for resistance measurement, and if a discontinuity is detected, the deposition process may be presumed.

US 2004/0209004 A1 discloses a method for depositing metal patterns on a substrate. The patterns are formed by ejecting bubbles of a liquid containing the metal onto the substrate and subsequently irradiating an ultraviolet ray onto the liquid, which is adapted for reacting with the ultraviolet ray and thereby depositing the metal on the substrate. The amount of deposited metal is controlled by varying the dosing of the ultraviolet ray.

### SUMMARY OF THE INVENTION

With the above it is an object of the present invention to provide a method of generating an electrical component on a substrate, said method being specially adapted to the requirements of the hearing aid technology and enables production of electrical components by material deposition on a substrate with high precision of their characteristic parameter values by comparatively simple and cost-effective method steps.

This object, in accordance with the present invention, is achieved by a method having the steps and features of attached claim 1.

Advantageous embodiments are subject-matter of the further claims dependent from claim 1.

It is an important feature of the present invention that it is during the production of electrical components by material deposition on a substrate for a hearing aid electrical circuitry that the characteristic parameter value of interest is continuously or quasi-continuously measured during production and it is not any dimension or property of the deposited material only resulting in a characteristic parameter value, which is monitored.

### BRIEF DESCRIPTION OF THE DRAWINGS

The invention will be well understood from the following description of several embodiments in connection with the attached drawings in which:
- Fig. 1: is a schematic, partly perspective view of a system for implementing the method of the invention;
- Fig. 2: is a similar view of another system in accordance with a modified embodiment for implementing the method of the present invention;
- Fig. 3: is a diagram showing the dependency of the desired value of a characteristic parameter, of an electrical component produced in accordance with the invention, from a dimension in the material deposition direction; and
- Fig. 4: is a schematic, partly perspective view of an example that is not part of the invention.

### DESCRIPTION OF THE PREFERRED EMBODIMENTS

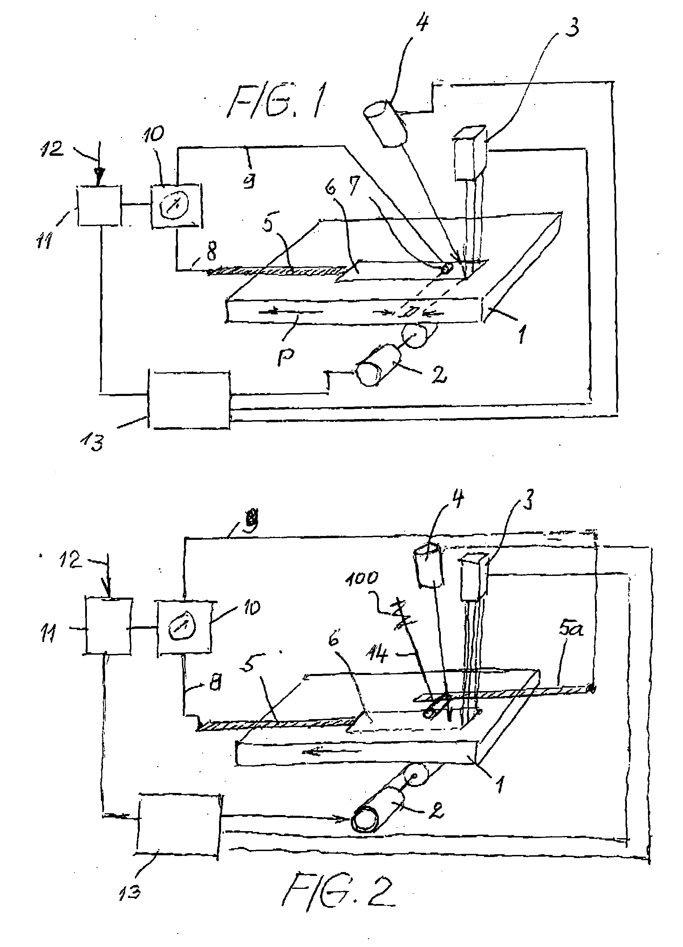

Referring now to Fig. 1 of the drawings, there is shown a dielectric substrate 1 which, by a controllable drive mechanism 2, is movable in direction of arrow P relative to a stationary ink deposition head 3 and a stationary curing heat energy emitting laser 4. The ink deposition head 3 and the laser 4 are installed vertically above the surface of the substrate 1 so that the ink deposition head 3 can deposit ink for printing an electrical component on the surface of the substrate 1 and the laser 4 can cure the deposited ink immediately thereafter in the course of the movement of the substrate 1 in relation to the ink deposition head 3 and the curing energy emitting laser 4.

As shown in Fig. 1, one terminal conductor 5 is deposited on the surface of the substrate 1 before depositing a pattern of conductive ink material deposition by the ink deposition head 3, said pattern of conductive ink material deposition 6 being shown as beginning at one end of the terminal conductor 5 and extending from this end of the terminal conductor 5 to a measuring probe 7 which contacts the surface of the deposited and cured pattern 6 of ink material in a sliding or rolling relation in order to make electrical contact to the deposited pattern 6 which, after production, forms the electrical component to be generated.

The terminal conductor 5 and the measuring probe 7 form two terminals connected via measuring lines 8 and 9, respectively, to a measuring device 10 the output measuring signal of which is fed to a comparator 11 which, in turn, as a further input, receives a predetermined threshold value via line 12.

If and as soon as the output measuring value of the measuring device 10 reaches the predetermined threshold value input to the comparator 11, the comparator 11 outputs a signal to a control unit 13 which, in response to this signal from the comparator 11, generates switch-off signals for deactivating the ink deposition head 3, the laser 4 and also the drive mechanism 2 for moving the substrate 1.

If the deactivation of the ink deposition head 3, of the laser 4 and of the drive mechanism 2 takes place immediately upon generation of the output signal of the comparator 11, then the pattern length from the beginning of the pattern at the end of terminal conductor 5 to the point of contact of the measuring probe 7 is the electrical component the characteristic parameter of which is measured by the measuring device 10 and is compared with the predetermined threshold value at line 12 in comparator 11. Therefore, in this case, the pattern 6 extending from the end of the terminal conductor 5 to the point of contact of the measuring probe 7 is the electrical component having precisely the desired value which, in combination with electrical components of other parts of the hearing aid electrical circuitry, meets the precision requirements without necessity of a trimming or tuning or adjusting step after deposition of this electrical component.

A necessary condition for making use of this advantage, however, is to connect the pattern 6 in the finished electrical circuitry to a second terminal conductor at a point where the measuring probe 7 had contacted the surface of the pattern 6 last, when deposition and curing of the deposited ink had been terminated.

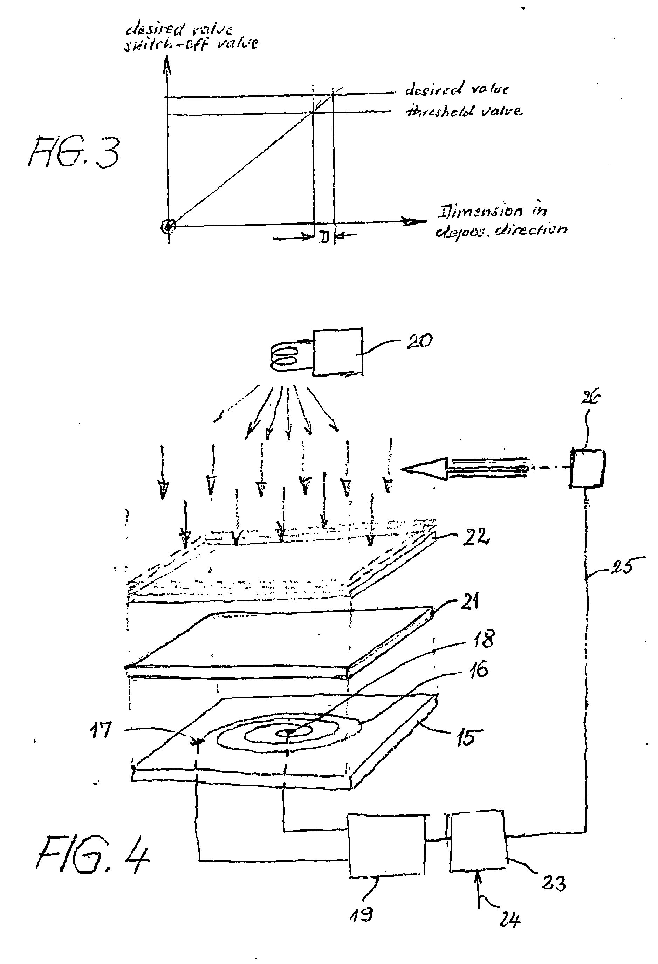

In a modified embodiment of the system shown in Fig. 1, however, the predetermined threshold value input on line 12 of comparator 11 could be selected a bit lower than a desired characteristic parameter value of the deposited pattern 6 if, thereafter continuing deposition of deposited ink causes a continuous increase of the respective characteristic parameter, to finally reach the desired value. Therefore, if the switch-off value input at line 12 of the comparator 11 is a bit lower than the desired value of the electrical component, then comparator 11 generates an output signal a short time before the measuring device 10 measures the precise desired value of the characteristic parameter of the electrical component in shape of the pattern between the end of the terminal conductor 5 and the measuring probe 7. The control unit 13, thereupon, generates switch-off signals to terminate operations of the ink deposition head 3, of the laser 4 and of the drive mechanism 2 in such manner that the ink deposition head 3 is switched-off nearly immediately, the laser 4 is switched-off with a short delay thereafter in order to finish curing of all deposited material and finally the drive mechanism 2 is switched-off. This has the consequence that it is not the partial length of the pattern 6 from the end of the terminal conductor 5 to the contact point of the measuring probe 7 which forms the electrical component with the precise desired characteristic parameter value but it is the whole length of the deposited pattern with only minimal deviations from the desired value of the characteristic parameter because of the not-monitored production phase of the partial length of the deposited pattern between the contact point of the measuring probe 7 and the deposition front generated by the ink deposition head 3. As shown in Figures 1 and 3, possible small tolerance deviations could only be introduced in the small deposition path marked D in Figures 1 and 3, respectively.

From the above description of the embodiment of Fig. 1 it becomes clear that, in the finished electrical circuitry, a connection from the second end of the deposited pattern to other electrical components has to be generated in a following manufacturing step exactly from the point of the pattern in length direction, where the pattern section to the measuring probe 7 or the pattern section from its beginning to its end has the precise desired characteristic parameter for resulting finally in the desired performance of the electrical circuitry.

If, in accordance with the embodiment of Fig. 2, two laterally offset terminal conductors 5 and 5a are predeposited on the surface of substrate 1, a rolling or gliding probe 14 corresponding generally to the measuring probe 7 of the embodiment of Fig. 1 could be used for bridging a just deposited and just cured section of the deposited pattern 6 with the second terminal conductor 5a. The lines 8 and 9 for coupling the measuring device 10 to a section of the deposited pattern 6 the characteristic parameter of which is to be monitored, are in this case connected to the terminal conductors 5 and 5a, whereas the probe 14 being installed stationary as the depositing head and the laser and being biased by spring means 100 against the surface of the deposited pattern 6 and the surface of the terminal conductor 5a, has no connection to any measuring means and serves only for bridging a just deposited and cured section of the pattern 6 with the second terminal conductor 5a.

Thus, after terminating the operation of the ink depositing head 3, the curing energy emitting laser 4 and the drive mechanism 2, in analogy with the considerations pointed out in connection with Fig. 1, a constant conductor bridge between the just finished section of the deposited pattern 6 and the second terminal conductor 5a has to be established either at the location where the probe 14 had last contacted the pattern 6 and the terminal conductor 5a or, if switching-off of the ink depositing head 3 and of the laser 4 had taken place with delay, from the end of the pattern 6 to the adjacent edge of the second terminal conductor 5a.

In any case, however, making the deposition of the electrical component 6 dependent from an online measuring of a characteristic parameter of this electrical component or of an already existing group of components including said electrical component ensures that a high preciseness of the characteristic parameter is achieved.

The person skilled in the art can appreciate that the deposited material can be conductor material for generating conductive paths of predetermined conductivity or predetermined resistance or for generating inductive components, e.g. inductors in shape of conductor spirals or for generating capacitor electrodes of deliberate shape.

If the deposited material is a conductor material serving for generating a shunt path of a predetermined resistance value, the deposition of the resistive conductor material can be carried out between parallel terminal conductors predeposited on a substrate and resulting in a shunt connection of the terminal conductors the monitored resistance of which decreases with increasing length of the deposited resistive conductor material bridging the two parallel terminal conductors. A corresponding system for implementing this method has not been shown in the drawings but can be realized by a person skilled in the art without difficulty.

Moreover, the deposited material could be a resistive material or a conductor material for generating a shielding for hearing aid electrical circuitry or parts thereof with a predetermined shielding effect.
Fig. 4 of the drawings depicts schematically a system for implementing a method that is not part of the invention.

A substrate 15 is provided on its upper surface with a spiral shaped conductive deposition 16 which forms an inductor or an inductive antenna between terminal conductors 17 and 18. The inductor 16 is coupled via the terminal conductors 17 and 18 to a measuring device 19 for measuring a current through the inductor 16 inductively coupled to it by any external noise from a noise source 20 symbolically indicated in Fig. 4. A dielectric insulating layer 21 and an electrically conductive shielding layer 22 are shown in Fig. 4 in explosion view. In a practical example the surface of the substrate 15 and the inductor 16 are laminated together with the insulating layer 21 and the conductive shielding layer 22 is deposited thereon by printing, spraying or in any other suitable manner in order to gradually increase the area and/or the thickness of the shielding layer 22.

Simultaneously therewith, the noise signal transmitter 20 sends noise signals of predetermined frequency down through the continuously growing shielding layer 22 and the insulating layer 21 to the spiral shaped inductor 16. As soon as the noise signal induced in the inductor 16 and measured via the terminal conductors 17 and 18 by the measuring device 19 decreases below a desired value, a comparator 23 comparing the output signal from the measuring device 19 with a threshold value on an input line 24 sends out a control signal via line 25 to a shutter mechanism 26 which, thereupon, interrupts deposition of the shielding material forming the shielding layer 22.

The example of Fig. 4 could be modified by feeding to the spiral shaped inductor 16 from a signal source a test signal of predetermined frequency and predetermined intensity and monitoring the propagation of such signal from the inductor 16 acting as an inductive antenna through the insulating layer 21 and the continuously growing shielding layer 22 to a measuring receiver the output of which serves for operation of the shutter mechanism 26 which terminates depositing of the shielding conductor material as soon as a predetermined shielding effect is reached.

If the shielding effect by the deposited shielding layer 22 influences the resonance frequency of an oscillator circuit which includes the spiral shaped inductor 16 as part thereof, then monitoring of the oscillator frequency and dimensioning of the shielding layer correspondingly could be useful for a precise tuning of the oscillator frequency by the manufacture of the shielding.

The above explanations elucidate that the method steps suggested by the present invention allow production of electrical components or electrical component groups of hearing aid electrical circuitry with extraordinarily high precision achieved by the mere production step which can be carried out by production equipment which does not suffer from high sophistication and is apt to miniaturization as required in the electronic hearing aid technology.

## Claims

1. Method of generating an electrical component of an electrical circuitry, particularly of a hearing aid, on a substrate (1), comprising the steps of
- providing a first terminal conductor (5) allocated to said electrical component;
- generating, in at least one material deposition step and by means of an ink deposition head (3) moved in relation to said substrate (1) along a surface of said substrate (1), the electrical component (6); and
- measuring, via said terminal conductor, characteristic parameters of said electrical component - and dimensioning the electrical component in accordance with a desired value of a characteristic parameter of the electrical component;
- controlling the material deposition in accordance with the measured value of the characteristic parameter;
- whereby the material deposition is terminated as soon as said measured value reaches a predetermined desired value of the respective characteristic parameter.
**characterized by** the step of
- measuring continuously, or quasi-continuously in a manner approximating continuous measurement, during the material deposition step or steps, the value of the characteristic parameter of the electrical component (6), said continuous or quasi-continuous measuring being carried out via at least one movable terminal conductor probe (7, 14) moved relatively to and in electrical contact with the deposited material synchronously with a deposition speed in one coordinate direction along the substrate (1);

2. Method in accordance with claim 1, **characterized in that** said continuous or quasi-continuous measuring is carried out via a second terminal conductors (5a) of said electrical component while said material deposition step or steps modulate at least one dimension of the deposited material between said terminal conductors.

3. Method in accordance with claim 1 or 2, **characterized in that** a deposition material curing radiation source, particularly a laser (4) or a UV radiation source, is moved relative to the substrate (1) synchronously behind the ink deposition head (3).

4. Method in accordance with claim 3, **characterized in that** said at least one moveable terminal conductor probe (7, 14) contacts the surface of the deposited and cured ink material (6) in a sliding or rolling relation.

5. Method in accordance with one of the claims 1 to 4, **characterized in that** the deposited Material is a conductor material for generating a capacitor electrode or for generating a conductive path or for generating an inductive electrical component.

6. Method in accordance with one of the claims 1 to 4, **characterized in that** the deposited material is a dielectric material.

7. Method in accordance with one of the claims 1 to 4, **characterized in that** the deposited material is a resistive material for generating electrical components having a predetermined resistance.

8. Method in accordance with claim 5, **characterized in that** the deposited material is a conductive material for generating an electromagnetic shielding of predetermined shielding effect.

## Patentansprüche

1. Verfahren zum Erzeugen einer elektrischen Komponente eines elektrischen Schaltkreises, insbesondere von einem Hörgerät, auf einem Substrat (1), mit den Schritten:
- Vorsehen eines ersten Anschlussleiters (5), der der elektrischen Komponente zugewiesen ist;
- Erzeugen der elektrischen Komponente (6) durch wenigstens einen Materialabscheideschritt und mittels eines Tintendruckkopfes (3), der bezüglich des Substrats (1) entlang einer Oberfläche des Substrats (1) bewegt wird; und
- Messen charakteristischer Parameter der elektrischen Komponente über den Anschlussleiter und Dimensionieren der elektrischen Komponente in Übereinstimmung mit einem gewünschten Wert des charakteristischen Parameters der elektrischen Komponente;
- Steuern der Materialabscheidung in Übereinstimmung mit dem gemessenen Wert des charakteristischen Parameters;
- wobei die Materialabscheidung beendet wird, sobald der gemessene Wert einen vorgegebenen gewünschten Wert des charakteristischen Parameters erreicht,
**gekennzeichnet durch** den Schritt:
- Kontinuierliches Messen oder einem kontinuierlichen Messen angenäherten quasi-kontinuierliches Messen des Wertes des charakteristischen Parameters der elektrischen Komponente (6) während des Materialabscheideschritts oder der Materialabscheideschritte, wobei das kontinuierliche Messen oder das dem kontinuierlichen Messen angenäherte, quasi-kontinuierliche Messen über wenigstens eine bewegliche Anschlussleitersonde (7) erfolgt, die relativ zum abgeschiedenen Material, und mit dem Material elektrisch in Kontakt stehend, synchron zu einer Abscheidegeschwindigkeit in einer Koordinatenrichtung entlang des Substrats (1) bewegt wird.

2. Verfahren nach Anspruch 1, **dadurch gekennzeichnet, dass** das kontinuierliche oder quasi-kontinuierliche Messen über einen zweiten Anschlussleiter (5a) der elektrischen Komponente erfolgt, während der Materialabscheideschritt oder die Materialabscheideschritte wenigstens eine Dimension des zwischen den Anschlussleitern abgeschiedenen Materials modulieren.

3. Verfahren nach Anspruch 1 oder 2, **dadurch gekennzeichnet, dass** eine das Abscheidematerial härtende Strahlungsquelle, insbesondere ein Laser (4) oder eine UV-Strahlungsquelle, relativ zum Substrat (1) synchron dem Tintendruckkopf (3) nachgeführt wird.

4. Verfahren nach Anspruch 3, **dadurch gekennzeichnet, dass** die wenigstens eine bewegliche Anschlussleitersonde (7, 14) die Oberfläche des abgeschiedenen und gehärteten Tintenmaterials (6) in rollender oder gleitender Manier kontaktiert.

5. Verfahren nach einem der Ansprüche 1 bis 4, **dadurch gekennzeichnet, dass** das abgeschiedene Material ein leitfähiges Material zum Erzeugen einer Kondensatorelektrode, eines leitfähigen Pfades oder einer induktiven elektrischen Komponente ist.

6. Verfahren nach einem der Ansprüche 1 bis 4, **dadurch gekennzeichnet, dass** das abgeschiedene Material ein Dielektrikum ist.

7. Verfahren nach einem der Ansprüche 1 bis 4, **dadurch gekennzeichnet, dass** das abgeschiedene Material ein resistives Material zum Erzeugen elektrischer Komponenten mit einem vorgegebenen Widerstand ist.

8. Verfahren nach Anspruch 5, **dadurch gekennzeichnet, dass** das abgeschiedene Material ein leitfähiges Material zum Erzeugen einer elektromagnetischen Abschirmung mit einer vorgegebenen Abschirmwirkung ist.

## Revendications

1. Procédé de génération d'un composant électrique d'un circuit électrique, en particulier d'une aide auditive, sur un substrat (1), comprenant les étapes consistant à :
- prévoir un premier conducteur de borne (5) alloué audit composant électrique ;
- générer le composant électrique (6), en au moins une étape de dépôt de matériau et au moyen d'une tête de dépôt d'encre (3) déplacée par rapport audit substrat (1) le long d'une surface dudit substrat (1) ; et
- mesurer des paramètres caractéristiques dudit composant électrique, via ledit conducteur de borne, et dimensionner le composant électrique en fonction d'une valeur souhaitée d'un paramètre caractéristique du composant électrique ;
- contrôler le dépôt de matériau en fonction de la valeur mesurée du paramètre caractéristique ;
- le dépôt de matériau étant terminé dès que ladite valeur mesurée atteint une valeur souhaitée prédéterminée du paramètre caractéristique concerné,
**caractérisé par** l'étape consistant à :
- mesurer en continu, ou quasiment en continu d'une manière qui approxime une mesure continue, pendant la ou les étapes de dépôt de matériau, la valeur du paramètre caractéristique du composant électrique (6), ladite mesure continue ou quasi-continue étant exécutée via au moins une sonde de conducteur de borne mobile (7, 14) déplacée par rapport au matériau déposé, et en contact électrique avec celui-ci, en synchronisme avec une vitesse de dépôt dans une direction de coordonnée le long du substrat (1).

2. Procédé selon la revendication 1, **caractérisé en ce que** ladite mesure continue ou quasi-continue est exécutée via un deuxième conducteur de borne (5a) dudit composant électrique, tandis que la ou lesdites étapes de dépôt de matériau modulent au moins une dimension du matériau déposé entre lesdits conducteurs de bornes.

3. Procédé selon la revendication 1 ou 2, **caractérisé en ce qu'**une source de rayonnement de durcissement de matériau de dépôt, en particulier un laser (4) ou une source de rayonnement UV, est déplacée par rapport au substrat (1), en synchronisme derrière la tête de dépôt d'encre (3).

4. Procédé selon la revendication 3, **caractérisé en ce que** ladite au moins une sonde de conducteur de borne mobile (7, 14) entre en contact avec la surface de l'encre déposée et durcie (6), selon une relation de glissement ou de roulement.

5. Procédé selon l'une quelconque des revendications 1 à 4, **caractérisé en ce que** le matériau déposé est un matériau conducteur pour la génération d'une électrode de condensateur, ou pour la génération d'un chemin conducteur, ou pour la génération d'un composant électrique inductif.

6. Procédé selon l'une quelconque des revendications 1 à 4, **caractérisé en ce que** le matériau déposé est un matériau diélectrique.

7. Procédé selon l'une quelconque des revendications 1 à 4, **caractérisé en ce que** le matériau déposé est un matériau résistif pour la génération de composants électriques ayant une résistance prédéterminée.

8. Procédé selon la revendication 5, **caractérisé en ce que** le matériau déposé est un matériau conducteur pour la génération d'un blindage électromagnétique d'un effet de blindage prédéterminé.
